# EUROPEAN PATENT APPLICATION

(11) **EP 4 682 552 A1**
(43) Date of publication of application: **21.01.2026**
(21) Application number: 24188735.5
(22) Date of filing: 16.07.2024
(51) Int. Cl.: G01R 29/08, G01R 35/00

(54) **A METHOD AND APPARATUS FOR AUTOMATIC CALIBRATION OF A VECTOR NETWORK ANALYSER**

(71) Applicant: Robert Bosch GmbH, 70442 Stuttgart (DE)
(72) Inventor: Erdei, Bence, 2220 Vecses (HU)

(57) **Abstract**

A method and system for calibration of a vector network analyser (2) of the measurement apparatus (1) wherein calibration components (10) are connected automatically by a connector positoner system (3) of the measurement apparatus (1) under control of a controller to ports of the vector network analyser (2) of the measurement apparatus (1).

## Description

### Technical Field

The invention relates to a method and apparatus for fully automated calibration of a vector network analyser (VNA) and to a motorized calibration component used by a calibration system for automatic calibration of a vector network analyser (VNA).

### Prior art

A vector network analyzer (VNA) is a measurement instrument adapted to measure S-parameters of multiport networks (transmission, reflection) in the frequency domain. The vector network analyzer is an instrument which can be used for analyzing passive and active components such as filters, amplifiers, mixers and multiport modules. The vector network analyzer features excellent RF characteristics and a wide variety of analysis functions that help the user to evaluate important parameters of a multiport network dorming a device under test (DUT) at a glance.

A conventional method of calibration of a vector network analyzer involves the alternate use of shorts, opens, loads, and a thru (direct connection of VNA test ports) using a known high precision standard calibration components in place of the device under test. This method may be time consuming and expensive, requiring a range of different standards and or adapters to approximate a range of desired DUTs. Further, each time the test system is assembled with a different standard or configuration, the interconnections between components may become worn or damaged, introducing further errors into the calibration. Also, the connections and reconnections themselves may cause erroneous calibrations due to variances in the torque, contact surface area, contact pressure and or alignment between the various connectors. In many cases, no standard similar to the DUT exists. Further, it may be impossible to connect available standards to each other, the vector network analyser and or the DUT.

US 8041528 B2 describes an arrangement comrising a vector network analyser (VNA), a set of calibration components configured to connect to the VNA, and a wireless interface for wirelessly communicating between the VNA and a respective one of the calibration components connected to the VNA. The VNA is configured to treat a calibration mode a connected calibration component as a measuring object, and calculate error terms from actual measured values and characteristic data of the connected component saved to a memory of the VNA. The VNA is further configured to output in a measuring mode measuring results which are corrected for connected measuring objects according to the error terms. Each calibration component comprises a transponder with a non-volatile memory which contains, as non-changeable data, at least the type of the component and an individual identification number and, as changeable data, at least the number of calibration processes performed with this calibration component. The wireless interface is configured to read at least the non-changeable data from the respective calibration component and increment the stored number of the calibration processes performed with the respective calibration component. Manual conection of the calibration components is required. This makes the involvement of an operator necessary and increses the calibration time.

### SUMMARY OF THE INVENTION

The invention provides according to a first aspect a method for calibration of a vector network analyzer of a measurement apparatus wherein calibration components are connected automatically under control of a controller by a connector positoner system of the measurement apparatus to ports of the vector network analyzer of the measuremt apparatus to perform a calibration of the vector network analyzer in a calibration routine.

The calibration routine comprises one or more calibrations steps wherein each calibration step of the calibration routine can make use of an associated calibration component positioned by the connector positioner system.

The calibration method according to the first aspect of the present invention does not require a manual replacement of calibration components by a user.

This reduces the required calibration time for calibration of the vector network analyzer significantly. Moreover calibration errors due to a manual handling of the calibration components are avoided.

In a possible embodiment of the method for calibration of a vector network analyzer the used calibration components comprise motorized calibration components and/or non-motorized calibration components.

Hereby calibration flexibility for a wider range of use cases is increased.

In a possible embodiment of the method for calibration of a vector network analyzer a driving motor of a motorized calibration componentis is controlled to adjust a matching load. The driving motor can be a stepper motor.

In a possible embodiment of the method for calibration of a vector network analyzer the connector positioner system applies a mating force to the calibration component. This provides a reliable electrical connection.

In a possible embodiment of the method for calibration of a vector network analyzer the calibration components used during the automated calibration of the vector network analyser comprise a short calibration standard component, an open calibration standard component, a thru (trough)-calibration standard component, a fixed match calibration standard component and a motorized sliding match calibration standard component.

In a possible embodiment of the method for calibration of a vector network analyzer the connector positioner system comprises a three-dimensional connector positioner system used for perfoming connections in three spatial dimensions.

The invention provides according to further aspect an automated calibration system used for calibration of the vector network analyser of a measurement apparatus wherein the automated calibration system comprises a connector positioner system adapted to connect automatically calibration components to ports of the vector network analyser of the measurement apparatus to perform a calibration of the vector network analyzer.

In a possible embodiment of the automated calibration system the connector positioner system comprises a three-dimensional connector positioner system adapted to perfom connections in three spatial dimensions in resonse to a control signal provided by a controller of the automated calibration system.

In a possible embodiment of the automated calibration system the calibration components comprise motorized calibration components and/or non-motorized calibration components.

In a possible embodiment of the automated calibration system the calibration components used during the automated calibration of the vector network analyser comprise a short calibration standard component, an open calibration standard component, a thru (trough)-calibration standard component, a fixed match calibration standard component and a motorized sliding match calibration standard component. One or more specific sets of calibration components for different use cases and/or different vector network analysers can be available and be accessible by the three-dimensional connector positioner system. The controller can select a specific set of calibration components and then a specific calibration component within the selected set. The selected calibration component is applied in a calibration step of the calibration routine to ports of the vector network analyser to be calibrated.

The invention further provides a motorized calibration component for calibration of a vector network analyser comprising a sliding match calibration standard component driven by an integrated motor of the motorized calibration component.

In a possible embodiment of the motorized calibration component a control interface of the motorized calibration component is adapted to receive a control signal from a controller used to control the motor integrated in motorized calibration component for adjusting a matching load.

The controller can be a controller of an automated calibration system or a controller of a measurement apparatus.

The controller can als comprise a controller of the vector network analyser to be calibrated. This allows the vector network analyser to perfom a self-calibration without human intervention.

The invention further provides a method for measuring a performance of a waveguide antenna module using a vector network analyzer having been calibrated by a calibration method according to the first aspect of the present invention, wherein the measurement method comprises the steps of:
connecting a first port of the calibrated vector network analyser to an antenna element of the waveguide antenna module and connecting a second portof the calibrated vector network analyzer to another antenna element of the waveguide antenna module;
radiating an electromagnetic wave from an antenna element of the waveguide antenna module reflected back by a corner reflector;
measuring a transmission signal indicating the power transmitted from the first port of the calibrated vector network analyser to the second port of the calibrated vector network analyser; and
applying time gating to the measured transmission signal to isolate the signal reflection from the corner reflector and to filter out unwanted reflections from surrounding surfaces, wherein the resulting frequency domain signal is processed to provide performance parameters of the waveguide antenna module.

In a possible embodiment of the method for measuring a performance of a multi-channel waveguide antenna module the ports of the calibrated vector network analyser are connected automatically by means of connectors of the connector positioner system to the antenna elements of the multi-channel waveguide antenna module.

In a possible embodiment of method for measuring a performance of a multi-channel waveguide antenna module the connectors of the connector positioner system are applied to the antenna elements of the multi-channel waveguide antenna module with a mating force for connection with the ports of the calibrated vector network analyser via flexible waveguides.

A waveguide antenna module is a metallized plastic or metal structure which contains a feed network and multiple radiating elements in one package. A waveguide antenna module can be used within a radar sensor.

A waveguide antenna module is a metallized plastic or metal structure which contains a feed network and multiple radiating elements in one package. A waveguide is a closed metal structure which can conduct electromagnetic waves.

An antenna element of the waveguide antenna module is a device which is adapted to transform conducted electricity to free space wave propagation and vice versa. An antenna measurement is a process when the spatial emission of an antenna is measured with the use of measurement instruments.

The measurement method using the calibrated vector network analyser provides a small form factor, a high reproducibility and a fast measurement time.

The measurement method using the calibrated vector network analyser allows an easy and reproducible replacement of antenna modules as devices under test (DUT).

Further an automated measurement for all channel combinations of the multi-channel waveguide module can be performed.

The measurement method using the calibrated vector network analyser provides a high stability over long term while having low maintenance needs.

The method provides in a possible embodiment a fully automated self-calibration thereby reducing the calibration time and calibration effort significantly.

In a possible embodiment of the method for measuring a performance of a multi-channel waveguide antenna module using the calibrated vector network analyser the frequency domain signal is processed to provide an antenna pattern for the antenna element of the waveguide antenna module.

In a possible embodiment of the method for measuring a performance of a multi-channel waveguide antenna module using the calibrated vector network analyser the frequency domain signal is processed to provide an antenna matching for the antenna element of the waveguide antenna module.

In a possible embodiment of the method for measuring a performance of a multi-channel waveguide antenna module using the calibrated vector network analyser the waveguide antenna module is mounted to plate of a first rotary stage of a rotary system and rotated around a surface normal of the plate to switch between an azimuth angle measurement with an adjustable azimuth angle and an elevation angle measurement with an adjustable elevation angle.This allows fast and easy testing of a waveguide antenna module over a wide range of possible angles.

In a possible embodiment of the method for measuring a performance of a multi-channel waveguide antenna module using the calibrated vector network analyser the waveguide antenna module is rotated by a second rotary stage of a rotary system along with the vector network analyser.

In a possible embodiment of the method for measuring a performance of a multi-channel waveguide antenna module using the calibrated vector network analyser all channel combinations of the multi-channel waveguide antenna module are measured automatically. This speeds up the measurement procedure and reduces the required measurement time for testing the multi-channel waveguide antenna module.

In a possible embodiment of the method for measuring a performance of a multi-channel waveguide antenna module using the calibrated vector network analyser the ports of the calibrated vector network analyser are connected automatically by means of connectors of a connector positioner system to the antenna elements of the multi-channel waveguide antenna module. This also speeds up the measurement procedure and reduces the required measurement time for testing the multi-channel waveguide antenna module.

In a possible embodiment of the method for measuring a performance of a multi-channel waveguide antenna module using the calibrated vector network analyser the connectors of the connector positioner system are applied to the antenna elements of the multi-channel waveguide antenna module with a mating force for connection with the ports of the calibrated vector network analyser via flexible waveguides.This also accelerates the measurement procedure and reduces the required measurement time for testing the multi-channel waveguide antenna module.

The high frequency vector network analyzer can be calibrated from time to time to ensure high accuracy measurements. The purpose of the calibration is mostly to compensate for channel transmission imperfections between the two (or multiple) ports of the vector network analyzer This increases the accuracy of the performed measurement significantly.

Different ways of calibration can be applied which all involve connecting specific standard components to the ports of the measuring line which will be connected to the device under test (DUT).

In a possible embodiment of the method for measuring a performance of a multi-channel waveguide antenna module using the calibrated vector network analyser the measurement of the measurement parameters of the multi-channel waveguide antenna module is performed in a frequency range between 60 to 90 GHz.

In a possible embodiment of the method for measuring a performance of a multi-channel waveguide antenna module using the calibrated vector network analyser the multi-channel waveguide antenna module comprises radar antenna elements. The radar antenna module can comprise an automotive multi-channel radar module used for a driver assistance system of a vehicle.

The invention further provides according to a further aspect a measurement apparatus or test system used for measuring a performance of a multi-channel waveguide antenna module using a vector network analyser calibrated by the calibration method according to the first aspect of the present invention. The measurement apparatus comprises a vector network analyser having a first port and a second port. The measurement apparatus further comprises a connector positioner system adapted to connect the first port of the calibrated vector network analyser to an antenna element of the multi-channel waveguide antenna module and to connect the second port of the calibrated vector network analyser to another antenna element of the waveguide antenna module. The calibrated vector network analyzer of the measurement apparatus is adapted to measure a transmission signal indicating the power transmitted from the first port of the calibrated vector network analyser to the second port of the calibrated vector network analyser (VNA). This can be performed while an antenna element of the multi-channel waveguide antenna module is radiating electromagnetic waves which is reflected back by a corner reflector of the measurement apparatus. Time gating is applied to the measured transmission signal to isolate the signal reflection from the corner reflector and to filter out unwanted reflections from surrounding surfaces. The resulting frequency domain signal is processed by a processor of the vector network analyser of the measurement apparatus to provide performance parameters of the multi-channel waveguide antenna module.

In a possible embodiment of the measurement apparatus a rotary system is provided having a first rotary stage and a second rotary stage, wherein the waveguide antenna module is mounted to plate of the first rotary stage of said rotary system and rotated around a surface normal of the plate to switch between an azimuth angle measurement with an adjustable azimuth angle and an elevation angle measurement with an adjustable elevation angle, and wherein the waveguide antenna module is rotated by the second rotary stage of said rotary system along with the vector network analyser of the measurement apparatus.

### Detailed Description

In the following possible embodiments of the method and apparatus according to the present invention are described in more detail with reference to the enclosed figures.
- Fig.1: shows a flowchart of a possible exemplary embodiment of the method for measuring a performance of a multi-channel waveguide antenna module using a vector network analyser calibrated by a method according to a first aspect of the present invention;
- Fig.2: shows a block diagram of a possible exemplary embodiment of a measurement apparatus for measuring a performance of a multi-channel waveguide antenna module using a vector network analyser calibrated according to a method of the present invention;
- Fig. 3: illustrates an exemplary possible implementation of a positioner system of a measurement apparatus for measuring a performance of a multi-channel waveguide antenna module;
- Fig. 4: illustrates exemplary standard calibration components used for calibration of a vector network analyser by a calibration method and calibration system according to the present invention;
- Fig.5: illustrates exemplary motorized standard calibration component used for calibration of a vector network analyser by a calibration method and calibration systemaccording to the present invention;
- Fig.6: illustrates an exemplary multi-channel waveguide antenna module inside a radar sensor which can measured using a vector network analyser calibrated according to a calibration method of the present invention;

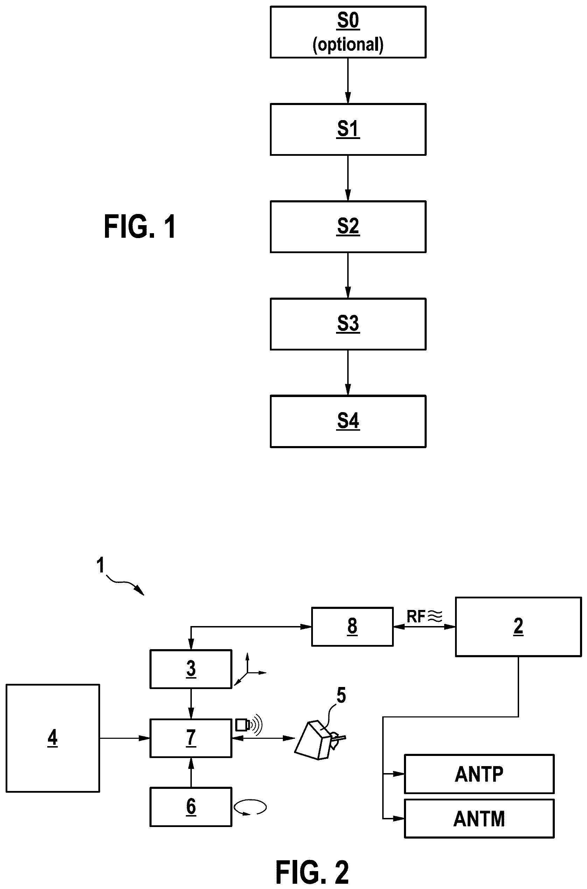

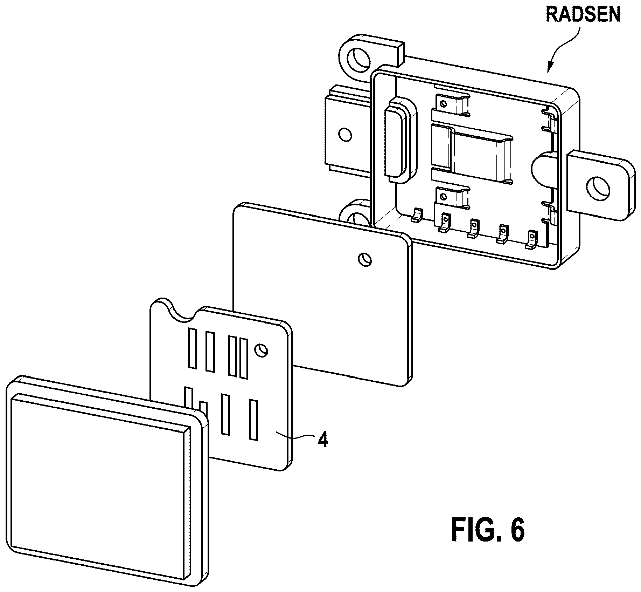

As illustrated in the flow chart of Fig.1 a method for measuring a performance of a multi-channel waveguide antenna module (WAM) as an exemplary device under test (DUT) comprises in a possible embodiment several main steps S1 to S4. The investigated waveguide antenna module 4 can form part of an automotive radar sensor RADSEN as illustrated in Fig 6.

Before the measurement method comprising steps S1 to S4 is initiated calibration steps of a calibration routine S0 take place. The calibration routine for calibration of the of the vector network analyser (VNA) can be performed in a preferrerd embodiment automatically by an automatic calibration system according to an aspect of the present invention without manual operation of a user.

The measurement method illustrated in Fig.1 can be performed by a measurement program comprising program instructions adapted to perform steps S1 to S4. The measurement program can be loaded from a program memory and then be executed on a controller of the measurement device 1.

In a first step S1 of the measurement method a first port (Port1) of the calibrated vector network analyser (VNA) 2 of a measurement apparatus 1 as illustrated in the schematic diagram of Fig.2 is connected to an antenna element of the waveguide antenna module 4 and a second port (Port2) of the calibrated vector network analyzer 2 is connected to another antenna element of the waveguide antenna module 4.

In a further step S2 an electromagnetic wave is radiated from an antenna element of the waveguide antenna module 4 and reflected back by a corner reflector 5 of the measurement apparatus 1. The antenna element of the waveguide antenna module 4 can be selected in response to a control signal.

In a further step S3 a transmission signal indicating the power transmitted from the first port (Port1) of the calibrated vector network analyser 2 to the second port (Port2) of the calibrated vector network analyser 2 is measured. The vector network analyser (VNA) 2 is adapted to measure the magnitude and phase of the scattering parameters (S-parameters) of each channel or antenna element combination, which are essential for understanding how signals behave as they pass through or reflect off components. A measured S21- transmission parameter indicates how much power passes through the respective channel.

In a further step S4 of the method time gating is applied to the measured transmission signal to isolate the signal reflection from the corner reflector 5 and to filter out unwanted reflections from surrounding surfaces. The resulting frequency domain signal is processed to provide performance parameters of the waveguide antenna module 4.

The time gating applied in step S4 of the method according to the present invention works comprises in a possible embodiment the following substeps: The corner reflector 5 is provided at a known distance from the measurement point in a setup of the measurement apparatus 1. This distance can be adjustable in possible implementation or fixed in an alternative implementation.

An S21 measurement is performed by the calibrated vector network analyser 2, which captures the transmitted signal over a range of frequencies and includes both the desired reflection from the corner reflector 5 and unwanted reflections from other objects. The measured stray parameter (S21) signal is initially in the frequency domain. To apply time gating, this signal is transformed to the time domain using an Inverse Fast Fourier Transform (IFFT).

In the time domain, different reflections appear at different times. The reflection from the corner reflector 5 at the predefined distance does appear at a specific time corresponding to the round-trip travel time of the radiated electromagnetic wave (since the wave travels to the reflector and back). A time gate is applied around the expected arrival time of the reflection from the corner reflector 5. For a corner reflector 5 being provided at a specific distance, the round-trip time RTT can be calculated using the speed of light. The time gate is typically centered at this time with a small time window. This applied time gating isolates the signal corresponding to the reflection from the corner reflector 5, effectively filtering out other reflections.

The time-gated signal is then transformed back to the frequency domain using a Fast Fourier Transform (FFT).The resulting frequency-domain signal now primarily contains the information from the desired reflection, with minimal interference from other reflections.

In a possible embodiment of the method for measuring a performance of a multi-channel waveguide antenna module the frequency domain signal is processed by a processor of the vector network analyser 2 to provide an antenna pattern ANTP for the antenna element of the waveguide antenna module 4.

In a possible embodiment of the method for measuring a performance of a multi-channel waveguide antenna module the frequency domain signal is processed by a processor of the vector network analyser 2 to provide an antenna matching ANTP for the antenna element of the waveguide antenna module 4.

The antenna pattern ANTP and the antenna matching ANTP of a tested waveguide antenna module 4 can be output via a user interface as outputs of the vector network analyser 2 as illustrated in Fig.2. and/or stored in a data memory.

In a possible embodiment of the method for measuring a performance of a multi-channel waveguide antenna module the waveguide antenna module 4 is mounted to plate of an adapter board 7. A first rotary stage of a rotary system 6 can be used to rotate the plate around a surface normal of the plate to switch between an azimuth angle measurement with an adjustable azimuth angle and an elevation angle measurement with an adjustable elevation angle.

In a possible embodiment of the method for measuring a performance of a multi-channel waveguide antenna module the waveguide antenna module 4 can be rotated by a second rotary stage of the rotary system 6 of the measurement apparatus 1 along with the vector network analyser 2.

In a possible embodiment of the method for measuring a performance of a multi-channel waveguide antenna module all channel combinations of the multi-channel waveguide antenna module 4 are measured automatically under control of a controller of the measurement apparatus 1.

In a possible embodiment of the method for measuring a performance of a multi-channel waveguide antenna module the ports (Port1, Port 2) of the calibrated vector network analyser 2 are connected automatically by means of connectors of a connector positioner system 3 to the antenna elements of the multi-channel waveguide antenna module 4. The connector positioner system 3 is controlled by the controller of the measurement apparatus 1 or by a controller of the calibrated vector network analyser 2 itself to perform automatically a measurement routine according to steps S1 to S4.

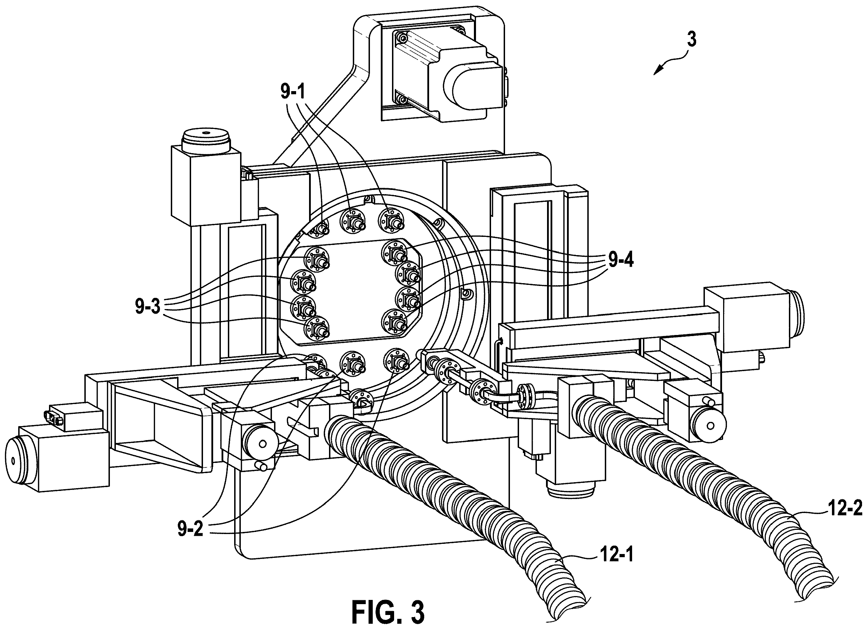

In a possible embodiment of the method for measuring a performance of the investigated or tested multi-channel waveguide antenna module 4 the connectors of the connector positioner system 3 are applied to the antenna elements of the multi-channel waveguide antenna module 4 with a mating force for connection with the ports (Port1, Port 2) of the calibrated vector network analyser 2 via flexible waveguides 12-1, 12-2 as also illustrated in Fig.3. Fig.3 shows a possible embodiment of a connector positioner system 3 of the measurement apparatus 1. The positioner system 3 shown in Fig.3 comprises ports 9-1, 9-2 for calibration and ports 9-3, 9-4 for module inputs of the waveguide antenna module 4.

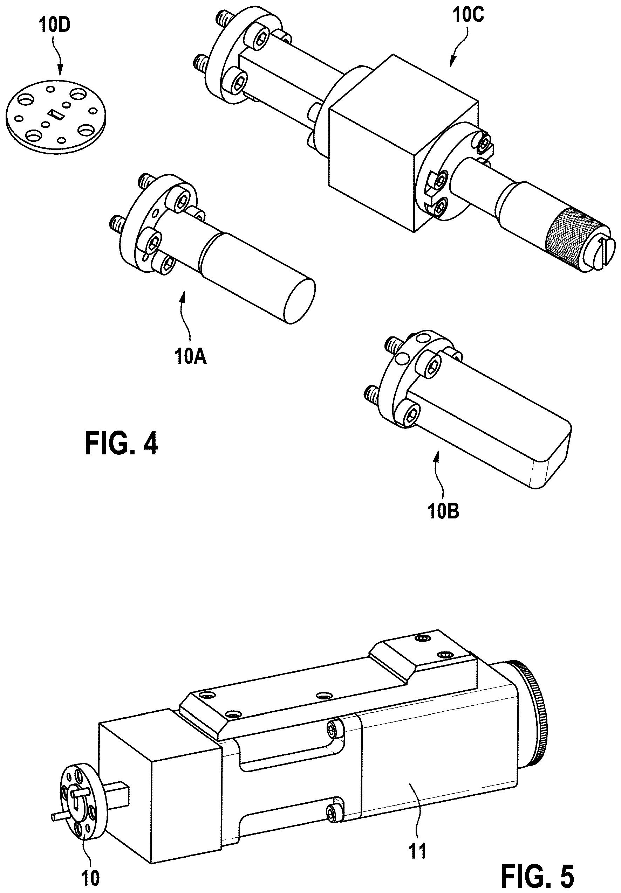

In a preferred embodiment of the method for measuring a performance of a multi-channel waveguide antenna module 4 an automated calibration of the vector network analyser 4 is performed in initial calibration routine S0 shown in the flowchart of Fig.1 using available calibration standard components 10 such as illustrated in Fig.4. The fully automated self-calibration can be performed in calibration routine S0 before the measurement method illustrated in the flow chart of Fig.1 is initiated, i.e. before step S1.

The calibration routine S0 can comprise several calibration substeps. In each calibration substep an associated calibration component 10 can be applied to perform calibration of the vector network analyser 2. The calibration routine S0 can be performed by a calibration program executed by a controller generating control siganals apllied to the connector positioner system 3 and/or to selected controllable calibration components 10. A controllable calibration component 10 comprises a control interface to receive a control signal from the controller. This control signal can control a driving motor integrated in the calibration component 10 to adjust a calibration paramenter such as a matching load.

One or more specific sets of calibration components 10 for different use cases and/or different vector network analysers 2 can be available and be accessible by the three-dimensional connector positioner system 3. The controller can select a specific set of calibration components and a specific calibration component 10 within the selected set. The selected calibation component 10 is applied in a calibration step of the calibration routine S0 to the vector network analyser 2 to be calibrated. If the selected calibration component 10 comprises a controllable calibration component, in particular a motorized calibration component, the controller can addititionally provide control parameters to the selected controllable calibration component 10 for adjustment. During the calibration routine S0 a sequence of selected calibration components 10 is applied to the ports of the vector network analyser 2 for its calibration. The sequence of selected calibration components 10 can include one or more controllable calibration components such as a sliding match calibration standard component 10 C as also shown in Fig.4.

The calibration routine S0 is triggered by an event and may be performed in a possible embodiment each time the vector network analyser 2 is energized, exposed to environmental changes or has changes made to the test frequency(s) or test system, i.e. the associated jumpers, connectors/adapters and or couplers used to couple the DUT with the vector network analyser 2 of the measurement apparatus 1.

The vector network analyser 2 is calibrated in the calibration routine S0 by identifying and quantifying systemic errors present in the test system. Vector network analysers are generally designed for use with several different methods of calibration to account for the different forms of test system errors. Each calibration step of the calibration routine S0 removes one or more of the systematic errors through vector error correction. Vector error correction may characterize the systematic errors by measuring, for example, calibration standards (devices with known s-parameters) then mathematically removing the effects of the systematic errors from subsequent measurements on the device under test (DUT).

The connector positioner system 3 can be used to connect calibration standard components 10 during the automated calibration of the vector network analyser 2. Conventional higher frequency calibration kits (~76GHz, used by automotive radars) always include manual work which is labour intensive and also prone to human assembly error. In contrast the measurement apparatus 1 comprises a connector positioner system 3 which can be controlled by a controller of the measurement apparatus 1 or by a controller of the vector network analyser 2 for performing an automated calibration in the calibration routine S0. The calibration standard components 10 used during the automated calibration routine S0 can comprise a short calibration standard component, an open calibration standard component, a thru (trough)-calibration standard component, a fixed match calibration standard component and a sliding match calibration standard component.

Fig. 4 illustrates a possible implantation of a short calibration standard component 10A, a fixed match calibration standard component 10B, sliding match calibration standard component 10C and a spacer plate used to achieve an open calibration standard component 10D. Fig. 5 illustrates a possible exemplary implementation of a motorized calibration standard component 10A driven by a controlled motor 11.

The short calibration standard component 10 A shown in Fig. 4 provides a short circuit where the impedance is very low (close to zero). The vector network analyser 2 measures the response, which should ideally be low impedance (zero). This calibration step helps the vector network analyser 2 to characterize the residual capacitance of the measurement setup.

The load calibration standard component 10 B provides a fixed matched load, usually 50 ohms. Also an adjustable matched load forming the characteristic impedance of the investigated system can be provided by a sliding match calibration component 10C as illustrated in Fig 4. The vector network analyser 2 measures the response, which should ideally match the system's characteristic impedance. This calibration step helps the vector network analyser 2 to characterize the reflection coefficient for a matched load.

The open calibration standard component 10D shown in Fig. 4 provides an open circuit where no current flows and the impedance is very high. The vector network analyser 2 measures the response, which should ideally be high impedance (infinite).This calibration step helps the vector network analyser 2 to characterize the residual inductance of the measurement setup.

The Thru -calibration standard component provides a direct connection between the two ports of the vector network analyser 2 used to measure transmission characteristics. The vector network analyser 2 measures the response to determine the transmission characteristics. This calibration step helps the vector network analyser 2 to account for any losses or phase shifts in the connection.

The calibration of the vector network analyser 2 with open, short, load, and thru standards is necessary for accurate measurements. By using the calibration standards, the vector network analyser 2 of the measurement apparatus 1 can correct for systematic errors in its measurement setup, ensuring reliable and precise characterization of RF and microwave components and systems.

The 3-axis positioner system 3 of the measurement apparatus 1 can also be used to connect the coaxial connectors and apply a suitable mating force to the calibration standard components 10 so that no human interaction becomes necessary. A TOSM principle can be used for the highest calibration accuracy with the following calibration standard components:
- Thru calibration standard component (known length section)
- Open calibration standard component (short + spacer)
- Short calibration standard component
- Fixed match calibration standard component
- Sliding match calibration standard component

In a preferred embodiment of the automated calibration system of the measurement apparatus 1 the sliding match calibration standard component 10 C is motorized as also shown in Fig.5. A precision stepper motor 11 can be used to move the sliding match calibration standard component 10C to the necessary position. In this way the full TOSM calibration can be performed in an automated way using the 3D positioner system 3 of the measurement apparatus 1. The automated calibration provides 100% automation in waveguide antenna testing (reflection, transmission). The driving motor or actuator 11 of the sliding match calibration standard component 10 C can be controlled in a preferred embodiment by a controller of a calibration system or by a controller of the vector network analyser 2 itself. This allows an automatic adjustment of a matching load under control of the controller of the calibration system or the vector network analyser 2.

In a possible embodiment of the method for measuring a performance of a multi-channel waveguide antenna module 4 the measurement of the measurement parameters of the multi-channel waveguide antenna module 4 is performed by the calibrated vector network analyser 2 in a frequency range between 60 to 90 GHz.

In a possible embodiment of the method for measuring a performance of a multi-channel waveguide antenna module the multi-channel waveguide antenna module 4 comprises radar antenna elements of a radar sensor RADSEN as illustrated in Fig.6.

The invention further provides according to a further aspect a measurement apparatus 1 used for measuring a performance of a multi-channel waveguide antenna module 4 as illustrated schematically in the block diagram of Fig.2.

The measurement apparatus 1 shown in Fig.2 comprises a vector network analyser (VNA) 2 having a first port (Port1) and a second port (port 2). The measurement apparatus 1 further comprises a connector positioner system 3 adapted to connect the first port (Port 1) of the vector network analyser 2 to an antenna element of the multi-channel waveguide antenna module (WAM) 4 as a device under test (DUT) and adapted to connect the second port (Port 2) of the vector network analyzer 2 to another antenna element of the waveguide antenna module 4. The connection via the microwave network 8 comprising waveguides for microwaves RF can be performed automatically.

The calibrated vector network analyser 2 of the measurement apparatus 1 is adapted to measure a transmission signal indicating the power transmitted from the first port (Port1) of the vector network analyser 2 to the second port (Port2) of the vector network analyser 2 while an antenna element of the multi-channel waveguide antenna module 4 is radiating electromagnetic waves which are reflected back by a corner reflector 5 of the measurement apparatus 1.

The corner reflector 5 is a device that reflects electromagnetic waves, such as radar signals, back towards the source. There are several types of corner reflectors 5, but they all share the same fundamental design principle. The corner reflector 5 consists in a possible implementation of three mutually perpendicular, intersecting flat surfaces (usually mirrors or metal plates), which form a corner. When the radiated electromagnetic wave hits this corner, it is reflected three times, one from each of the three surfaces, ultimately directing the wave back to its point of origin.

In a possible embodiment of the measurement apparatus 1 a rotary system 6 is provided having a first rotary stage and a second rotary stage. The waveguide antenna module (WAM) 4 as the device under test (DUT) can be mounted to a plate of an adapter board 7. A first rotary stage of the rotary system 6 can be controlled by a controller of the measurement apparatus 1 to rotate the plate round a surface normal of the plate to switch between an azimuth angle measurement with an adjustable azimuth angle and an elevation angle measurement with an adjustable elevation angle. The waveguide antenna module 4 can also be rotated by a second rotary stage of the rotary system 6 along with the vector network analyser 2. In a possible embodiment of the measurement apparatus 1 the apparatus comprises also an automated self-calibration system.

The measurement apparatus 1 provides a fully automated system which comprises in a possible embodiment as main components a two- port vector network analyzer (VNA) 2 with frequency extenders (60-90GHz), a first rotary stage of a rotary system 6 which is adapted to rotate the antenna module 4 around the surface normal to switch between azimuth and elevation measurement and a second rotary stage of the rotary system 6 which is adapted to rotate the full system with the two-port vector network analyzer (VNA) 2. The outputs of the vector network analyser 2 illustrated in the block diagram if Fig.2 are an antenna pattern ANTP (azimuth, elevation) and/or an antenna matching ANTM.

The measurement apparatus 1 can further comprise in a possible embodiment a 2 x 3 axis connector positioner system 3, two flexible waveguide sections, waveguide - coaxial transitions, quick connectors which do not need screw tightening. In a further embodiment of the measurement apparatus 1 a linear stage is provided which combined with another linear stage and a rotary stage allows to achieve a circular travel path.

A vector network analyser 2 can be used with two channels and with 60-90GHz frequency extenders. Port 1 is connected to one antenna, and port 2 is to another antenna in the module 4. A corner reflector 5 is used in a preferred embodiment as a target. To eliminate the need of absorber walls, time gating is used at the distance of the corner reflector (e.g. 1 m).Time gating is applied on the measured transmission (S21) signal in step S4 and only the filtered range (e.g.1 m ± 0.01 m) is transformed back to the frequency domain. Because of the time gating, no anechoic chamber needed. This leads to a compact form factor. On the whole angular range of the measurement the system can be rotated and the measurements can be performed.

In a possible embodiment two-way antenna patterns are recorded, and out of the multiple measurements the single channel antenna diagrams can be calculated with post processing. The two-way antenna pattern effectively describes the overall efficiency and directivity of the antenna element of the multi-channel waveguide antenna module 4.

The radiation pattern of an antenna element describes how it radiates energy into space. It can typically be represented in polar or cartesian coordinates and shows the relative power radiated by the antenna element in different directions. The reception pattern of an antenna element describes how it receives energy from different directions. This pattern is often the same as the radiation pattern due to the principle of reciprocity, which states that the transmission and reception characteristics of an antenna are identical.

The two-way antenna pattern can be obtained by combining the transmission and reception patterns. This can be done by multiplying the gain of the antenna element in the transmission direction by the gain in the reception direction.

For provision of an automated connection the 3-axis positioner system 3 of the measurement apparatus 1 can be used to connect the coaxial connectors and apply a mating force. The provision of flexible waveguides 12 allows the positioners to move freely. The whole plate where the antenna module 4 is mounted can be rotated for switching between elevation angle measurement or azimuth angle measurement. The coaxial connectors are used for utilizing the coaxial transmission mode which is not dependent on rotation around the axis.

The method and measurement apparatus 1 according to the present invention provide for an accurate gain and antenna pattern measurement and input matching measurement, in particular over a 72-82 GHz frequency range.

The method and measurement apparatus 1 according to the present invention provide in a possible embodiment for an angle measurement range of ±90° azimuth at 0° elevation, ±90° elevation at 0° azimuth and up to ±45° offset angles (for example ±90° azimuth at ±45° elevation).

Other advantages of the method and measurement apparatus 1 include a small form factor, a high reproducibility and a fast measurement time. The measurement method and measurement apparatus 1 using the calibrated NVA allow an easy and reproducible replacement of antenna modules 4 as devices under test (DUT). A fully automated calibration of the vector network analyser 2 and a subsequent automatic measurement for all channel combinations of the multi-channel waveguide module 4 can be performed. The measurement method and measurement apparatus provide a high stability over long term while having low maintenance needs. The method and apparatus provide in a possible embodiment a fully automated self-calibration thereby reducing the calibration effort significantly.

The embodiments illustrated in Fig.1 to 6 can be combined with each other.

While the invention has been described in detail with reference to specific embodiments thereof, it will be apparent to one of ordinary skill in the art that various changes and modifications can be made therein without departing from the spirit and scope thereof. Accordingly, it is intended that the present invention covers the modifications and variations of this invention provided they come within the scope of the appended claims and their equivalents.

## Claims

1. A method for calibration of a vector network analyser (2) of a measurement apparatus (1) wherein calibration components (10) are connected automatically by a connector positoner system (3) under control of a controller to ports of the vector network analyser (2) of the measuremt apparatus (1) for calibration of the vector network analyser (2).

2. The method for calibration of a vector network analyser accrding to claim 1 wherein the calibration components (10) comprise motorized calibration components and/or non-motorized calibration components.

3. The method for calibration of a vector network analyser according to claim 2 wherein a driving motor (11) of a motorized calibration component (10) is controlled to adjust a matching load.

4. The method for calibration of a vector network analyser according to any of the preceding claims 1 to 3 wherein the connector positioner system (3) applies a mating force to the calibration component (10).

5. The method for calibration of a vector network analyser according to any of the preceding claims 1 to 4 wherein the calibration components (10) used during the automated calibration of the vector network analyser (2) comprise a short calibration standard component (10A), an open calibration standard component (10D), a thru (trough)-calibration standard component, a fixed match calibration standard component (10B) and a motorized sliding match calibration standard component (10C).

6. The method for calibration of a vector network analyser according to any of the preceding claims 1 to 5 wherein the connector positioner system (3) comprises a three-dimensional connector positioner system used for perfoming connections in three spatial dimendions under control of the controller.

7. An automated calibration system used for calibration of the vector network analyser (2) of a measurement apparatus (1) wherein the automated calibration system comprises a connector positioner system (3) adapted to connect automatically calibration components (10) to ports of the the vector network analyser (2) of the measurement apparatus (1) for calibration of the vector network analyser (2).

8. The automated calibration system according to claim 7 wherein the connector positioner system (3) comprises a three-dimensional connector positioner system adapted to perfom connections in three spatial dimensions in resonse to a control signal provided by a controller of the automated calibration system.

9. The automated calibration system according to claim 7 or 8 wherein the calibration components (10) comprise motorized calibration components and/or non-motorized calibration components.

10. The automated calibration system according to claim 9 wherein the calibration components (10) used during the automated calibration of the vector network analyser (2) comprise a short calibration standard component (10A), an open calibration standard component (10D), a thru (trough)-calibration standard component, a fixed match calibration standard component (10B) and a motorized sliding match calibration standard component (10C).

11. A motorized calibration component for calibration of a vector network analyser (2) comprising a sliding match calibration standard component driven (10C) by an integrated motor (11) of the motorized calibration component.

12. The motorized calibration component according to claim 11 comrising a control interface adapted to receive a control signal from a controller used to control the motor (11) for adjusting a matching load.

13. A method for measuring a performance of a waveguide antenna module (4), using a vector network analyzer (2) calibrated by a calibration method according to any of the preceding claims 1 to 6, wherein the measurement method comprises the steps of:
connecting (S1) a first port (Port1) of the calibrated vector network analyser (2) to an antenna element of the waveguide antenna module (4) and connecting a second port (Port2) of the calibrated vector network analyzer (2) to another antenna element of the waveguide antenna module (4);
radiating (S2) an electromagnetic wave from an antenna element of the waveguide antenna module (4) reflected back by a corner reflector (5);
measuring (S3) a transmission signal indicating the power transmitted from the first port (Port1) of the calibrated vector network analyser (2) to the second port (Port2) of the calibrated vector network analyser (2); and
applying time gating (S4) to the measured transmission signal to isolate the signal reflection from the corner reflector (5) and to filter out unwanted reflections from surrounding surfaces, wherein the resulting frequency domain signal is processed to provide performance parameters of the waveguide antenna module (4).

14. The method for measuring a performance of a multi-channel waveguide antenna module according to claim 13 wherein the ports of the calibrated vector network analyser (2) are connected automatically by means of connectors of the connector positioner system (3) to the antenna elements of the multi-channel waveguide antenna module (4).

15. The method for measuring a performance of a multi-channel waveguide antenna module according to claim 14 wherein the connectors of the connector positioner system (3) are applied to the antenna elements of the multi-channel waveguide antenna module (4) with a mating force for connection with the ports of the vector network analyser (4) via flexible waveguides (12).
